# EUROPEAN PATENT APPLICATION

(11) **EP 4 148 812 A1**
(43) Date of publication of application: **15.03.2023**
(21) Application number: 21799739.4
(22) Date of filing: 28.04.2021
(51) Int. Cl.: H01L 41/187, H01L 41/312, H01L 21/02

(54) **PIEZOELECTRIC COMPOSITE SUBSTRATE AND METHOD FOR MANUFACTURING SAME**

(30) Priority: 08.05.2020 JP 2020082666
(71) Applicant: SHIN-ETSU CHEMICAL CO., LTD., Tokyo 1000005 (JP)
(72) Inventor: NAGATA, Kazutoshi, Annaka-shi, Gunma 379-0195 (JP)
(74) Representative: HGF
(86) International application number: PCT/JP2021/016935
(87) International publication number: WO 2021/225101

(57) **Abstract**

Provided are a piezoelectric substrate and a manufacturing method thereof, by which bonding strength enough for forming a piezoelectric layer on an insulating substrate having a significantly small linear expansion coefficient can be obtained through ion implantation even by heat treatment at 100°C or less. A piezoelectric composite substrate 10 having successively stacked insulating substrate 2, interlayer 3, and piezoelectric layer 1a is manufactured by laminating a piezoelectric single-crystal substrate surface having an ion implantation layer 1a thereon and an insulating substrate 2 having a linear expansion coefficient less than that of the piezoelectric single-crystal substrate 1 with a difference in a range of 14×10⁻⁶ /K to 16×10⁻⁶ /K via the interlayer 3 to obtain a bonded body 4, and after heat treatment, leaving the ion implantation layer 1a as a piezoelectric layer and releasing the remaining portion 1b of the piezoelectric single-crystal substrate from the bonded body 4. The insulating substrate 2 and the interlayer 3 are each made of a Si-containing amorphous material.

## Description

### TECHNICAL FIELD

The present invention relates to a piezoelectric composite substrate and to a method for manufacturing the same.

### BACKGROUND ART

As a component for frequency adjustment and making a selection on cellular telephones and the like, a surface acoustic wave (SAW) device having, on the piezoelectric substrate thereof, an interdigital transducer (IDT) for exciting surface acoustic waves has been used. The surface acoustic wave device is required to be compact, have small insertion loss, and have the ability to stop passage of spurious waves through the device, for this, piezoelectric materials such as lithium tantalate (LiTaO₃; abbreviated as LT) and lithium niobate (LiNbO₃; abbreviated as LN) are used.

According to the communication standards for cellular telephones of the fourth and subsequent generations, on the other hand, the frequency band interval is narrow and the band width is wide in transmission and reception. Under such communication standards, a piezoelectric material used for surface acoustic wave devices is required to have as small as possible temperature-dependent property variation. In manufacturing a SAW device, variation in the thickness of a piezoelectric material leads to variation in SAW velocity, so the film thickness should be controlled with high precision.

It is reported in Non-Patent Document 1 or Non-Patent Document 2 that a substrate obtained by bonding an LT substrate to a sapphire substrate or silicon substrate having a linear expansion coefficient less than that of the LT substrate and grinding the LT into a thin film has suppressed effects of thermal expansion of an oxide single-crystal and has thereby improved temperature properties.

Examples of a substrate thinning method other than grinding include manufacturing methods of an SOI wafer such as Smart-Cut method. In brief, it is a method of laminating a silicon wafer having a hydrogen ion layer formed thereon with a supporting wafer and heat treating the resulting laminate at around 500°C to thermally release the ion implantation layer (Patent Document 1). To increase the efficiency in using an oxide single-crystal wafer for products, attempts have been made to replace the silicon wafer of the Smart-Cut method by an oxide single-crystal wafer to form an oxide single-crystal thin film on the supporting wafer (Non-Patent Document 3, Non-Patent Document 4).

According to the report of Non-Patent Document 3, an LTMOI (Lithium - tantalate-metal-on-insulator) structure is formed by forming a 121-nm thick Cr metal layer on the surface of an LT wafer having an ion implantation layer formed thereon, laminating the resulting wafer with an SiO₂ substrate having a thickness of several hundred nm via the metal layer, heat treating the laminate at 200 to 500°C to release it at the ion implantation layer, transferring an LT thin film on the SiO₂ substrate via the metal layer, and laminating the LT wafer with the SiO₂ substrate on the side opposite to the surface of the substrate on which the LT thin film has been transferred. According to the report of Non-Patent Document 4, a silicon wafer is laminated with an LT wafer having an ion implantation layer formed thereon, the resulting laminate is heat treated at 200°C to release it at the ion implantation layer, and thus, an LT thin film is thermally transferred onto the silicon wafer.

Patent Document 2 describes a method of laminating an LT substrate with a substrate of a different kind via an adhesive.

### REFERENCE DOCUMENT LIST

### PATENT DOCUMENTS

Patent Document 1: JP H05-211128 A
Patent Document 2: JP 2010-187373 A

### NON-PATENT DOCUMENTS

Non-Patent Document 1: Transactions of The Institute of Electronics, Information and Communication Engineers A Vol. J98-A, No. 9, pp. 537-544
Non-Patent Document 2: Taiyo Yuden Co., Ltd., "Temperature compensation technology for SAW-Duplexer used in RF front end of smartphone." [online], November 8, 2012, Dempa Shimbun High Technology, searched on March 20, Heisei 27, internet <URL: http://www.yuden.co.jp/jp/product/tech/column/20121108.html>
Non-Patent Document 3: A Tauzin et al., "3-inch single-crystal LiTaO3 films onto metallic electrode using Smart CutTM technology", Electric Letters, 19th June 2008, Vol.4 4, No. 13, p. 822
Non-Patent Document 4: Weill Liu et al., "Fabrication of single-crystalline LiTaO3film on silicon substrate using thin film transfer technology", J. Vac. Sci. Technol. B26(1), Jan/Feb 2008, p. 206

### SUMMARY OF THE INVENTION

### PROBLEM TO BE SOLVED BY THE INVENTION

The method of manufacturing a composite substrate including grinding, which is described in Non-Patent Document 1 or Non-Patent Document 2, has a problem in that deterioration in film-thickness uniformity occurs with thinning of a piezoelectric substrate.

It is reported in Non-Patent Document 3 that a structure having a metal layer and an SiO₂ substrate between an LT wafer and thin film makes it possible to suppress exfoliation or cracking of the wafer due to a difference in thermal expansion during heat treatment and thereby transfer the LT thin film. This method, however, does not overcome the aforesaid problem of a piezoelectric material in temperature stability because the underlayer substrate and the thin film are made of the same material, that is, LT. In addition, the thin film cannot be transferred without conducting a heat treatment at 200°C or more. Furthermore, the composite substrate has a metal layer sandwiched therein so that use of it is limited. Moreover, expensive LT should be used in an amount greater than necessary in order to suppress cracking of the wafer, and this increases manufacturing cost.

Non-Patent Document 4 describes that heat treatment was conducted at 200 to 800°C. In the specific example, however, transfer of an LT thin film on a silicon wafer by a Smart-Cut method was performed only at 200°C and in this example, there is no description on whether the LT thin film was transferred on the entire surface of the silicon wafer.

The present inventor carried out a verification experiment on the release by the heat treatment at 200°C by using a method similar to that of Non-Patent Document 3. The thin film was not transferred onto the entire surface of the silicon wafer, and transfer was observed only in a small portion thereof. In particular, the LT thin film was not transferred at all on the peripheral portion of the silicon wafer, which is presumed to occur because the wafer to be laminated was warped due to a difference in thermal expansion between the wafers during the heat treatment, and peeling occurred from the lamination interface of the LT wafer at the peripheral portion of the silicon wafer. It is presumed that even if the heat treatment is conducted at 200°C or more, the warping of the wafer to be laminated due to difference in thermal expansion between them cannot be suppressed, and the LT thin film cannot be stably transferred onto the entire surface of the silicon wafer, as described above. The method of manufacturing a composite substrate including ion implantation treatment has such a problem that heat treatment is essential, as described above, although a thin film with excellent film-thickness uniformity can be formed.

With a view to forming a substrate having improved temperature properties, the present inventor tried to form an LT film on a quartz substrate (Table 1) having a linear expansion coefficient smaller than that of sapphire or silicon. However, it was revealed that due to a very large difference in expansion coefficient between the substrates, the deformation amount of the composite substrate was large even at a temperature as low as 100°C or less and the substrate remained deformed or broke after the heat treatment, so that a grinding process was not applied. Release by ion implantation was tried, but only separation occurred at the LT-quartz interface due to a low heat treatment temperature.

The method using an adhesive as described in Patent Document 2 also has a problem in that in a composite substrate of an LT substrate and a quartz substrate, sufficient bonding strength cannot be achieved by the heat treatment at 100°C or less, which causes neither breakage nor separation of the substrate, and an LT film is difficult to form by grinding or ion implantation.

In consideration of the aforesaid problems, an object of the present invention is therefore to provide a piezoelectric composite substrate and a method of manufacturing the same by which bonding strength sufficient for forming a piezoelectric layer such as an LT film or an LN film on an insulating substrate, such as quartz substrate, having a significantly small linear expansion coefficient, can be achieved through ion implantation even at a heat treatment temperature of 100°C or less.

### MEANS FOR SOLVING THE PROBLEM

With a view to achieving the aforesaid object, provided as one aspect of the present invention is a piezoelectric composite substrate having successively stacked an insulating substrate, an interlayer, and a piezoelectric layer, in which the piezoelectric layer has a thickness in a range of 100 nm to 2,000 nm in a stacking direction, the insulating substrate has a diameter in a range of 2 inches to 12 inches and a plate thickness of 100 µm to 2,000 µm, the insulating substrate has a linear expansion coefficient smaller than that of the piezoelectric layer with a difference therebetween in a range of 14×10⁻⁶ /K to 16×10⁻⁶ /K, and the insulating substrate and the interlayer each have a Si-containing amorphous material.

The piezoelectric layer may contain lithium tantalate or lithium niobate. The insulating substrate may be a quartz substrate. The interlayer may contain amorphous silicon or silicon dioxide.

Provided as another aspect of the present invention is a method of manufacturing a piezoelectric composite substrate having successively stacked insulating substrate, interlayer, and piezoelectric layer, including a step of preparing a piezoelectric single-crystal substrate and an insulating substrate having a linear expansion coefficient less than that of the piezoelectric single-crystal substrate with a difference therebetween falling within a range of 14×10⁻⁶ /K to 16×10⁻⁶ /K, and has a Si-containing amorphous material; a step of subjecting a surface of the piezoelectric single-crystal substrate to be laminated to ion implantation treatment to form an ion implantation layer in the piezoelectric single-crystal substrate; a step of forming an interlayer with a Si-containing amorphous material on one or both of the respective surfaces of the insulating substrate and the piezoelectric single-crystal substrate to be laminated; a step of laminating the surface of the insulating substrate to be laminated with the surface of the piezoelectric single-crystal substrate to be laminated via the interlayer to obtain a bonded body; a step of heat treating the bonded body; and a step of leaving the ion implantation layer as a piezoelectric layer and releasing the remaining portion of the piezoelectric single-crystal substrate from the heat-treated bonded body.

In the step of forming the interlayer, the Si-containing amorphous material may contain amorphous silicon or silicon dioxide, and the interlayer may be formed by CVD, sputtering, or spin coating.

### EFFECTS OF THE INVENTION

According to the present invention, even if an insulating substrate having a linear expansion coefficient significantly less than that of a piezoelectric layer with a difference therebetween falling in a range of 14×10⁻⁶ /K to 16×10⁻⁶ /K and being made of an Si-containing amorphous material is used, formation of an interlayer having a Si-containing amorphous material between the piezoelectric layer and the insulating substrate enables to achieve bonding strength sufficient to form the piezoelectric layer by ion implantation even at a heat treatment temperature of 100°C or less.

### BRIEF DESCRIPTION OF THE DRAWINGS

FIG. 1 is a schematic flow chart for explaining one embodiment of the method of manufacturing a piezoelectric composite substrate according to the present invention.
FIG. 2 is a schematic view for explaining the deformation amount of a bonded substrate measured in Comparative Example 2.

### MODE FOR CARRYING OUT THE INVENTION

One embodiment of the piezoelectric composite substrate and manufacturing method thereof according to the present invention will hereinafter be described with reference to the attached drawings, but the scope of the present invention is not limited to or by it.

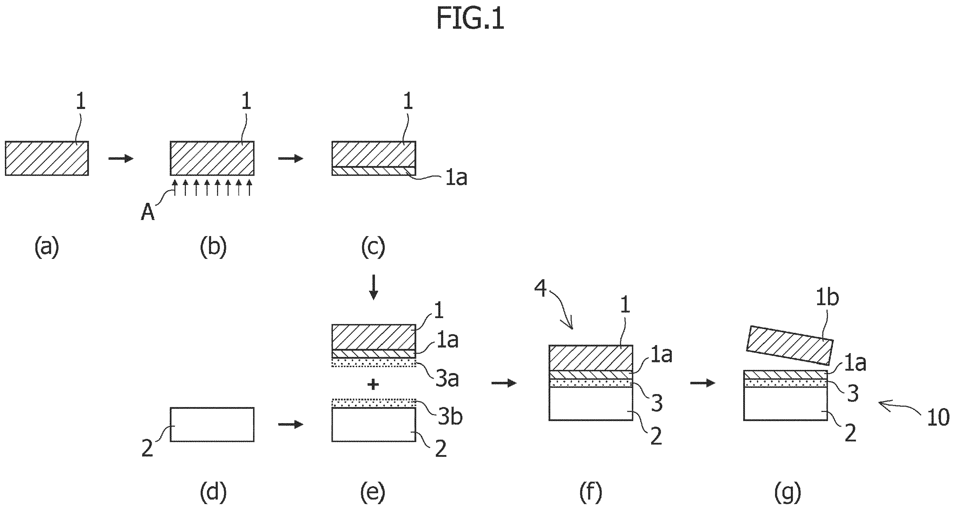

The method of manufacturing a piezoelectric composite substrate of the present embodiment includes, as shown in FIG. 1, a step of preparing a piezoelectric single-crystal substrate 1 ((a) in FIG. 1), a step of subjecting the piezoelectric single-crystal substrate 1 to ion implantation treatment ((b) in FIG. 1), a step of thereby forming an ion implantation layer 1a in the piezoelectric single-crystal substrate 1 ((c) in FIG. 1), a step of preparing an insulating substrate 2 ((d) in FIG. 1), a step of forming an interlayer 3 on the piezoelectric single-crystal substrate 1 and the insulating substrate 2 ((e) in FIG. 1), a step of laminating the piezoelectric single-crystal substrate 1 with the insulating substrate 2 via the interlayer 3 ((f) in FIG. 1), and a step of releasing a portion 1b of the piezoelectric single-crystal substrate from the bonded body 4 obtained by lamination to obtain a piezoelectric composite substrate 10 ((g) in FIG. 1). Each of these steps will next be described in detail.

The piezoelectric single-crystal substrate 1 prepared in the step (a) is a substrate made of a piezoelectric single crystal. As a piezoelectric body, known ones may be used, and those having a compound composed of lithium, a metal element such as tantalum or niobium, and oxygen are preferred. Examples of such a compound include lithium tantalate (LiTaO₃; abbreviated as LT) and lithium niobate (LiNbO₃; abbreviated as LN). The piezoelectric single-crystal substrate 1 may be used in the form of a wafer. The size of the wafer is not particularly limited, and it may have, for example, a diameter of 2 to 12 inches and a plate thickness of 100 to 1000 µm. As the piezoelectric single-crystal substrate 1, that is commercially available in the form of a wafer or that is obtained by processing a piezoelectric single-crystal ingot into the form of a wafer by slicing or the like, may be used.

In the step (b), the surface of the piezoelectric single-crystal substrate 1 to be laminated is subjected to ion implantation treatment A. As shown in the step (c), by this treatment, an ion implantation layer 1a is formed on the surface of the piezoelectric single-crystal substrate 1 to be laminated. Ion implantation treatment with a hydrogen atom ion (H⁺) is preferably performed under the conditions of a dose of 5.0×10¹⁶ atoms/cm² to 2.75×10¹⁷ atoms/cm². A dose less than 5.0×10¹⁶ atoms/cm² is unlikely to cause embrittlement of the ion implantation layer in a subsequent step. When the dose is greater than 2.75×10¹⁷ atoms/cm², microcavities are generated in the ion implanted surface during ion implantation, and they form irregularities on the wafer surface, making it difficult to obtain desired surface roughness. A hydrogen molecule ion (H₂⁺) is preferably implanted in a dose of 2.5×10¹⁶ atoms/cm² to 1.37×10¹⁷ atoms/cm²

The accelerating voltage of ions is preferably 50 KeV to 200 KeV The ion implantation depth can be changed by adjusting the accelerating voltage.

An insulating substrate prepared in the step (d) as the insulating substrate 2 has a linear expansion coefficient lower than that of the piezoelectric single-crystal substrate 1 at a temperature between 298 K (about 25°C) and 673 K (about 400°C) with a difference between these substrates being in a range of 14×10⁻⁶ /K to 16×10⁻⁶ /K. For example, when the piezoelectric single-crystal substrate 1 is made of lithium tantalate (LT), an insulating substrate having a linear expansion coefficient in a range of 2.1×10⁻⁶ /K to 0.1×10⁻⁶ /K is used as the insulating substrate 2 because LT has a linear expansion coefficient of 16.1×10⁻⁶/K. It is to be noted that the linear expansion coefficient between a temperature of 298 K and 673 K is a value obtained by measuring the linear thermal expansion coefficients in a temperature range of 298 K to 673 K in accordance with JIS R3102:1995 by a differential thermal dilatometer (TMA) and averaging them. The linear expansion coefficient of various materials is shown in Table 1.

**Table 1**

| Material | LT | LN | Sapphire | Silicon | Quartz |
|---|---|---|---|---|---|
| Linear expansion coefficient [× 10⁻⁶/K] | 16.1 | 15.4 | 7.7 (400°C or less) | 2.6 | 0.54 |

The insulating substrate 2 which satisfies the conditions of the aforesaid difference in linear expansion coefficient from the piezoelectric single-crystal substrate 1 differs depending on the material of the piezoelectric single-crystal substrate 1 to be used, and examples include quartz, sapphire, and silicon substrates. By using the insulating substrate 2 having a linear expansion coefficient significantly smaller than that of the piezoelectric single-crystal substrate 1, a piezoelectric body to be bonded to the insulating substrate has improved temperature properties. The quartz substrate is a substrate substantially made of quartz (SiO₂). The total content of metal components, which are impurities in the quartz substrate, is preferably 20 mass ppm or less, more preferably 1 mass ppm or less.

The insulating substrate 2 may be used in the form of a wafer and with respect to the size, the wafer has a diameter of 2 to 12 inches and a plate thickness of 100 to 2,000 µm.

The surface of the piezoelectric single-crystal substrate 1 to be laminated and the surface of the insulating substrate 2 to be laminated are each preferably processed into a mirror surface by lapping polishing or the like. The surface roughness (RMS) of the surface to be laminated is preferably 1.0 nm or less. By adjusting the RMS to 1.0 m or less, these substrates can be bonded by lamination. The term "RMS" is also called "root mean square roughness Rq" as specified by JIS B 0601:2013.

Next, as shown in the step (e) in FIG. 1, interlayers 3a and 3b are formed on the surface of the piezoelectric single-crystal substrate 1 to be laminated and the surface of the insulating substrate 2 to be laminated. As the interlayer 3, an amorphous material containing silicon (Si) is used. Examples of the Si-containing amorphous material include an amorphous silicon film, a silicon oxide film, a silicon nitride film, and a silicon oxynitride film. Thus, by using the Si-containing amorphous material as the interlayer 3, sufficient bonding strength is secured between the piezoelectric single-crystal substrate 1 and the insulating substrate 2. The thickness of the interlayer 3 is not particularly limited and it is preferably, for example, 10 nm to 100 µm.

The method of forming such an interlayer 3 is, for example, chemical vapor deposition (CVD), sputtering, or spin coating. Examples of CVD include thermal CVD, plasma CVD, and photo CVD. Under the known film formation conditions for forming an amorphous silicon film or a silicon oxide film by the aforesaid CVD, sputtering, or spin coating, the interlayer 3 can be formed on the surface of the piezoelectric single-crystal substrate 1 or insulating substrate 2 to be laminated.

The step (e) in FIG. 1 shows that the interlayers 3a and 3b are formed on the respective surfaces of the piezoelectric single-crystal substrate 1 and the insulating substrate 2 to be laminated. The present invention is not limited to such a structure and similar effects can also be achieved only by forming the interlayer 3a on the surface of the piezoelectric single-crystal substrate 1 or only by forming the interlayer 3b on the surface of the insulating substrate 2 to be laminated.

Then, as shown in the step (f) in FIG. 1, the piezoelectric single-crystal substrate 1 and the insulating substrate 2 are laminated via the interlayer 3. Prior to the lamination, the respective surfaces of the piezoelectric single-crystal substrate 1 and the insulating substrate 2 to be laminated are subjected to surface activation treatment. The surface activation treatment is not particularly limited as long as it activates the surface to be laminated and examples include plasma activation treatment, ion beam irradiation treatment, UV ozone treatment, and ozone water treatment. Plasma treatment and ion beam treatment are particularly preferred. The surface activation treatment may be performed in an atmosphere using inert gases such as nitrogen and argon, or oxygen, either alone or in combination.

The bonded body 4 obtained by laminating the piezoelectric single-crystal substrate 1 and the insulating substrate 2 via the interlayer 3 is subjected to heat treatment. This heat treatment enhances the bonding strength and at the same time, enables release of the ion implantation layer 1a from the piezoelectric single-crystal substrate 1. In the release by the heat treatment, the implanted hydrogen ions form a microbubble layer in the substrate by the heat treatment, and then the resulting microbubble layer expands to release the ion implantation layer. The heat treatment temperature is preferably 100 to 200°C, more preferably 100 to 150°C, still more preferably 100 to 110°C. When the heat treatment temperature is higher than 400°C, due to a large difference in linear expansion coefficient between the piezoelectric single-crystal substrate 1 and the insulating substrate 2, the bonded body 4 warps and the deformation amount is large, so that the deformation may remain even after the heat treatment or the bonded body 4 may be broken. On the other hand, when the heat treatment temperature is lower than 100°C, the bonding strength is not enhanced or the microbubble layer does not expand sufficiently and in the subsequent step (g), the piezoelectric single-crystal substrate 1 may be released from the insulating substrate 2 at the lamination interface. The heat treatment time is, for example, preferably 1 to 100 hours.

Then, as shown in the step (g) in FIG. 1, a portion 1b of the piezoelectric single-crystal substrate is released from the heat-treated bonded body 4 while the ion implantation layer 1a is left on the side of the interlayer 3. This makes it possible to obtain a piezoelectric composite substrate 10 having the ion implantation layer (piezoelectric layer) 1a formed on the insulating substrate 2 via the interlayer 3. It is to be noted that at the time of this release, a mechanical shock may be given using a wedge-shaped blade or the like (omitted from the drawing).

Since the piezoelectric composite substrate 10 thus obtained uses the insulating substrate 2 having a linear expansion coefficient significantly less than that of the piezoelectric layer 1a, it overcomes the problem of a piezoelectric body, and therefore, has largely improved temperature properties. In addition, since the presence of the interlayer 3 improves the bonding strength between the piezoelectric layer 1a and the insulating substrate 2, exfoliation or cracking, which would otherwise occur by the heat treatment can be suppressed.

The method of manufacturing a piezoelectric composite substrate according to the present embodiment has been described referring to FIG. 1. The present invention is not limited to or by it, and it may include many modifications such as change in the order of the aforesaid steps or incorporation of another new step. For example, in FIG. 1, after formation of the ion implantation layer 1a in the piezoelectric single-crystal substrate 1 in the steps (b) and (c), the interlayer 3a is formed on the side of the ion implantation layer 1a of the piezoelectric single-crystal substrate 1 in the step (e). The present invention is not limited to this order, and after formation of the interlayer 3a on the surface of the piezoelectric single-crystal substrate 1 to be laminated, ion implantation treatment A may be performed from the side of the interlayer 3a of the piezoelectric single-crystal substrate 1. This makes it possible to form the ion implantation layer 1a on the side of the interlayer 3a of the piezoelectric single-crystal substrate 1 as in FIG. 1. Also in this case, a desired ion implantation layer 1a may be formed under ion implantation treatment conditions similar to those of the aforesaid step (b).

### EXAMPLES

Examples and Comparative Examples will hereinafter be described, but the present invention is not limited to or by them.

### Example 1

A lithium tantalate (LT) single-crystal ingot having a diameter of 4 inches was sliced, lapped, and polished into an LT single-crystal substrate having a thickness of 350 µm and a single-sided mirror surface. On the mirror surface side of the resulting LT single-crystal substrate, a 20-nm amorphous silicon film was formed by CVD.

Next, a quartz substrate having a double-sided mirror surface and a thickness of 400 µm was prepared as a supporting substrate. It was confirmed that the surface roughness RMS of the LT substrate and the quartz substrate on their mirror surface sides was 1.0 nm or less. The amorphous silicon-formed surface of the LT substrate was then subjected to ion implantation treatment under the conditions of a hydrogen ion (H⁺) dose of 1×10¹⁷ atoms/cm² and an accelerating voltage of 130 KeV

Then, the respective surfaces of the LT substrate and the quartz substrate to be bonded were subjected to plasma activation treatment and they were laminated with each other. The resulting bonded body was heated at 110°C for 24 hours and a portion of the LT substrate on the side opposite to the bonded surface was released. As a result, an LT-on-quartz composite substrate having an LT single-crystal film thinned to a thickness of 860 nm remaining on the quartz substrate was manufactured. The resulting composite substrate was heated at 120°C for 24 hours, but no release of the LT layer occurred. The composite substrate was heated further at 125°C for 12 hours, but no abnormalities were found in the composite substrate.

### Example 2

A lithium tantalate (LT) single-crystal ingot having a diameter of 4 inches was sliced, lapped, and polished and the 42° Rotated Y cut LT single-crystal substrate was finished into a piezoelectric single-crystal substrate having a thickness of 500 µm and a single-sided mirror surface. On the mirror surface side of the resulting LT single-crystal substrate, a silicon oxide film was formed by CVD, followed by polishing to form a 150-nm silicon oxide film on the LT mirror surface.

Next, a quartz substrate having a double-sided mirror surface and a thickness of 400 µm was prepared as a supporting substrate. It was confirmed that the surface roughness RMS of the LT substrate and the quartz substrate on their mirror surface sides was 1.0 nm or less. The LT substrate on the mirror surface side was then subjected to ion implantation treatment under the conditions of a hydrogen ion (H⁺) dose of 1.25×10¹⁷ atoms/cm² and an accelerating voltage of 175 KeV

Then, the respective surfaces of the LT substrate and the quartz substrate to be bonded were subjected to plasma activation treatment and they were laminated with each other. The resulting bonded body was heated at 100°C for 24 hours, and a portion of the LT substrate on the side opposite to the bonded surface thereof was released. As a result, an LT-on-quartz composite substrate having an LT single-crystal film thinned to a thickness of 1250 nm remaining on the quartz substrate was manufactured. The resulting composite substrate was heated at 120°C for 24 hours, but no release of the LT layer occurred. The composite substrate was heated further at 125°C for 12 hours, but no abnormalities were found in the composite substrate.

### Example 3

A lithium niobate (LN) single-crystal ingot having a diameter of 4 inches was sliced, lapped, and polished into an LN single-crystal substrate having a thickness of 500 µm and a single-sided mirror surface. On the mirror surface side of the resulting LN single-crystal substrate, a 20-nm thick amorphous silicon film was formed by CVD.

Next, a quartz substrate having a double-sided mirror surface and a thickness of 400 µm was prepared as a supporting substrate. It was confirmed that the surface roughness RMS of the LN substrate and the quartz substrate on their mirror surface sides was 1.0 nm or less. The amorphous silicon-formed surface of the LN substrate was then subjected to ion implantation treatment under the conditions of a hydrogen ion (H⁺) dose of 1×10¹⁷ atoms/cm² and an accelerating voltage of 130 KeV

Then, the respective surfaces of the LN substrate and the quartz substrate to be bonded were subjected to plasma activation treatment and they were laminated with each other. The resulting bonded body was heated at 110°C for 24 hours and a portion of the LN substrate on the side opposite to the bonded surface of thereof was released. As a result, an LN-on-quartz composite substrate having an LN single-crystal film thinned to a thickness of 900 nm remaining on the quartz substrate was manufactured. The resulting composite substrate was heated at 120°C for 24 hours, but no release of the LN single-crystal film occurred. The composite substrate was heated further at 125°C for 12 hours, but no abnormalities were found in the composite substrate.

### Comparative Example 1

A lithium tantalate single-crystal (LT) ingot having a diameter of 4 inches was sliced, lapped, and polished into an LT single-crystal substrate having a thickness of 350 µm and a single-sided mirror surface.

Next, a 400 µm-thick quartz substrate having a double-sided mirror surface was prepared as a supporting substrate. It was confirmed that the surface roughness RMS of the LT substrate and the quartz substrate on their mirror surface sides was 1.0 nm or less. The LT substrate on the mirror surface side was then subjected to ion implantation treatment under the conditions of a hydrogen ion (H⁺) dose of 1×10¹⁷ atoms/cm² and an accelerating voltage of 130 KeV

Then, the respective surfaces of the LT substrate and the quartz substrate to be bonded were subjected to plasma activation treatment, and they were laminated with each other. The resulting bonded substrate was heated at 110°C for 24 hours, but the LT substrate and the quartz substrate separated from each other at the lamination interface.

### Comparative Example 2

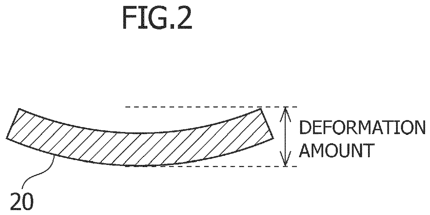

The LT single-crystal substrate and the quartz substrate used in Comparative Example 1 were subjected to plasma activation treatment and laminated with each other to obtain a bonded substrate. The resulting bonded substrate was heat treated to each temperature listed in Table 2 and the deformation amount of the bonded substrate at that time was measured. The results are shown in Table 2. The deformation amount of the bonded substrate was determined, as shown in FIG. 2, by placing the heat-treated bonded substrate 20 on a flat plate with the center concave portion of the substrate facing downward and measuring a difference in height between a portion in contact with the flat plate and a portion of the bonded substrate showing the largest deformation relative to the contact portion.

**Table 2**

| Heat treatment temperature [°C] | Deformation amount of bonded substrate [mm] |
|---|---|
| 40 | 0.5 |
| 60 | 2.0 |
| 70 | 2.0 |
| 80 | 3.0 |
| 90 | 3.5 |
| 100 | 4.0 |

Thus, when the LT substrate and the quartz substrate significantly differing in linear expansion coefficient were directly bonded to each other, the deformation amount of the bonded substrate was great even at a temperature as low as 100°C or less, as shown in Table 2, and the bonded substrate remained deformed even after heat treatment. On the other hand, the LT-on-quartz or LN-on-quartz composite substrate obtained in Examples 1 to 3 did not warp with such a large deformation amount even if it was heat treated at more than 100°C, as described above.

### REFERENCE SYMBOL LIST

1: Piezoelectric single-crystal substrate
1a: Ion implantation layer
2: Insulating substrate
3: Interlayer
10: Piezoelectric composite substrate
20: Bonded substrate

## Claims

1. A piezoelectric composite substrate comprising an insulating substrate, an interlayer, and a piezoelectric layer stacked successively, wherein the piezoelectric layer has a thickness in a range of 100 nm to 2,000 nm in a stacking direction, the insulating substrate has a diameter in a range of 2 inches to 12 inches and a plate thickness of 100 µm to 2,000 µm, the insulating substrate has a linear expansion coefficient smaller than that of the piezoelectric layer with a difference therebetween in a range of 14×10⁻⁶ /K to 16×10⁻⁶ /K, and the insulating substrate and the interlayer each have a Si-containing amorphous material.

2. The piezoelectric composite substrate according to Claim 1, wherein the piezoelectric layer comprises lithium tantalate or lithium niobate.

3. The piezoelectric composite substrate according to Claim 1 or 2, wherein the insulating substrate is a quartz substrate.

4. The piezoelectric composite substrate according to any one of Claims 1 to 3, wherein the interlayer comprises amorphous silicon or silicon dioxide.

5. A method of manufacturing a piezoelectric composite substrate having an insulating substrate, an interlayer, and a piezoelectric layer stacked successively, comprising the steps of:
preparing a piezoelectric single-crystal substrate and an insulating substrate having a linear expansion coefficient less than that of the piezoelectric single-crystal substrate with a difference therebetween falling within a range of 14×10⁻⁶ /K to 16×10⁻⁶ /K, and having a Si-containing amorphous material;
subjecting a surface of the piezoelectric single-crystal substrate to be laminated to ion implantation treatment to form an ion implantation layer in the piezoelectric single-crystal substrate;
forming an interlayer with a Si-containing amorphous material on one or both of the respective surfaces of the insulating substrate and the piezoelectric single-crystal substrate to be laminated;
laminating the surface of the insulating substrate to be laminated with the surface of the piezoelectric single-crystal substrate to be laminated via the interlayer to obtain a bonded body;
heat treating the bonded body; and
leaving the ion implantation layer as a piezoelectric layer and releasing the remaining portion of the piezoelectric single-crystal substrate from the heat-treated bonded body.

6. The method of manufacturing a piezoelectric composite substrate according to Claim 5, wherein in the step of forming the interlayer, the Si-containing amorphous material contains amorphous silicon or silicon dioxide and the interlayer is formed by CVD, sputtering, or spin coating.
